Europäisches Patentamt

European Patent Office

Office européen des brevets

(11) Numéro de publication : **0 323 926 B1**

(12) **FASCICULE DE BREVET EUROPEEN**

(45) Date de publication du fascicule du brevet :
30.09.92 Bulletin 92/40

(51) Int. Cl.$^5$ : **H05K 7/14**

(21) Numéro de dépôt : **89400010.8**

(22) Date de dépôt : **03.01.89**

(54) **Système de montage et de démontage rapide d'un châssis sur un bâti support.**

(30) Priorité : **08.01.88 FR 8800137**

(43) Date de publication de la demande :
**12.07.89 Bulletin 89/28**

(45) Mention de la délivrance du brevet :
**30.09.92 Bulletin 92/40**

(84) Etats contractants désignés :
**DE GB**

(56) Documents cités :
**GB-A- 926 768**
**US-A- 3 120 412**

(73) Titulaire : **THOMSON-CSF**
**51, Esplanade du Général de Gaulle**
**F-92800 Puteaux (FR)**

(72) Inventeur : **Darbo, Benoit**
**THOMSON-CSF SCPI 19, avenue de Messine**
**F-75008 Paris (FR)**
Inventeur : **Lacroix, Patrice**
**THOMSON-CSF SCPI 19, avenue de Messine**
**F-75008 Paris (FR)**

(74) Mandataire : **Sciaux, Edmond et al**
**THOMSON-CSF SCPI**
**F-92045 PARIS LA DEFENSE CEDEX 67 (FR)**

# Description

La présente invention concerne un système de montage et de démontage d'un châssis sur un bâti support.

L'invention s'applique avantageusement à des châssis électriques car l'enfichage (et le désenfichage) peut être produit simultanément au cours du montage (et du démontage). En outre, la vision d'un cadran ou d'un affichage cathodique ou autre sur la face avant du châssis est préservée par suite de l'absence pratiquement d'effet de masque par le système de montage.

Il est connu de mettre en place un châssis, par exemple un poste radio voiture, en le faisant coulisser dans un boîtier parallélépipédique pourvu d'un connecteur de raccordement correspondant à celui dont est équipé le châssis Le châssis constitué par le poste est d'un faible poids et se trouve disposé de manière inclinée vers le bas ; son maintien en place ne pose pas de problème particulier lors de l'utilisation du véhicule.

Le document GB-A-926 768 décrit une système selon le préambule de la revendication 1.

Le problème est différent pour des châssis beaucoup plus lourds, par exemple des visualisations à tube cathodique qui sont montées en position horizontale ou sensiblement horizontale, et dont le fonctionnement peut se produire dans une toute autre position compte tenu du mouvement du véhicule porteur, notamment si celui-ci est un avion. En outre, il faut tenir compte des conditions sévères d'environnement, en particulier des vibrations, conditions thermiques ou autres qui doivent être supportées par ces équipements.

Le système de montage proposé permet de résoudre ces problèmes avec une haute fiabilité et une très grande simplicité de manoeuvre, par des commandes manuelles simples sans nécessiter d'outillage, en procurant de manière simultanée le verrouillage avec enfichage des connecteurs et le déverrouillage avec désenfichage des connecteurs.

Suivant l'invention, il est proposé de réaliser un système de montage et de démontage rapide d'un châssis sur un bâti support, par translation horizontale du châssis, le système comportant :

– une poignée accessible à l'avant du châssis, couplée par ses extrémités à deux bras disposés latéralement au châssis, l'un à droite, l'autre à gauche, et tournant respectivement autour de deux axes mécaniques solidaires du châssis, chacun des bras comportant une partie échancrée ;

– deux pions venant respectivement se loger dans les parties échancrées des bras, le système étant caractérisé en ce que chaque pion est monté sur une pièce pouvant se déplacer selon la direction de translation du châssis et couplée mécaniquement à un ressort fixé au bâti, le ressort étant tendu pour exercer une force de traction selon ladite direction dans le sens du montage du châssis ; le système comportant en outre

– un dispositif de verrouillage de la poignée en position haute et un dispositif de butée mécanique limitant la course de chaque pièce support de pion selon ladite direction dans le sens du montage, la force de traction résultante des deux ressorts dans la position butée des deux pièces étant de valeur supérieure à celle nécessaire pour déplacer le châssis selon ladite translation.

Les particularités et avantages de l'invention apparaîtront dans la description qui suit, donnée à titre d'exemple à l'aide des figures annexées qui représentent :

– Fig.1, un schéma d'un système de montage et démontage conforme à l'invention montrant le châssis disposé dans le boîtier support et les divers éléments du système ;

– Fig.2, un schéma du bâti support équipé du système de montage et de démontage selon la figure 1 ;

– Fig.3, un schéma du châssis équipé du système de montage et de démontage de la figure 1 ;

– Figs.4A et 4B, des schémas simplifiés représentant respectivement les cotes principales servant à déterminer le système de montage et de démontage et le masque minimal procuré sur la face avant ;

– Figs.5A et 5B, un schéma d'un bras latéral et l'engagement du pion dans la partie échancrée avec détail de cette dernière partie ;

– Fig.6, un schéma simplifié du montage selon la figure 1 lorsqu'on procède à l'enfichage et au montage du châssis ;

– Fig.7, un schéma simplifié du montage selon la figure 1 lorsqu'on procède au démontage et au désenfichage du châssis.

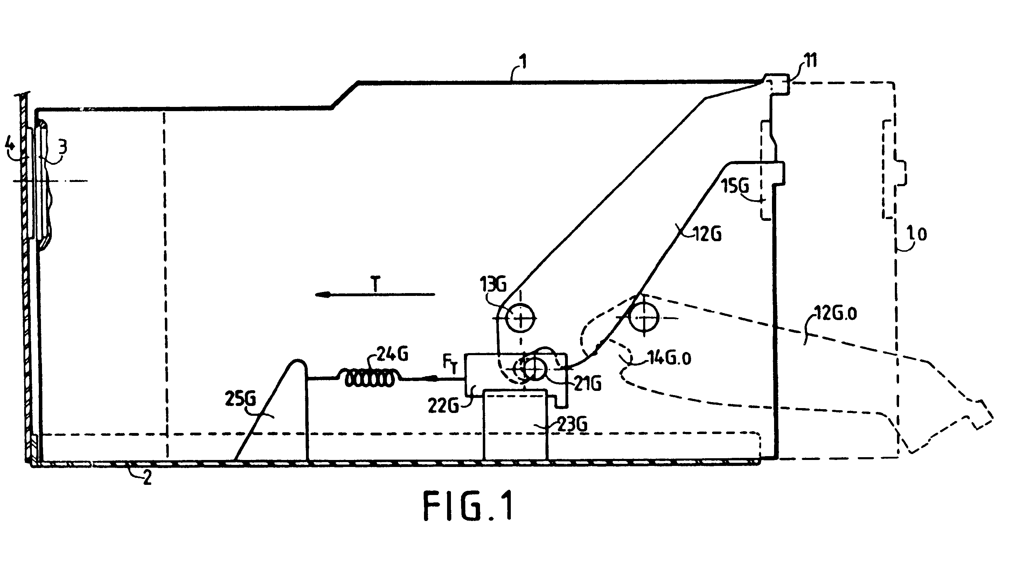

En se reportant à la figure 1, on distingue un châssis 1 devant être disposé sur un bâti support 2 (partie hachurée). Le montage du châssis s'effectue par translation horizontale selon la direction T. Le démontage s'effectue par déplacement horizontal dans le sens inverse. On a considéré, de manière non limitative pour l'invention, dans la version représentée le châssis pourvu d'un connecteur d'extrémité 3 sur la face arrière et le bâti comportant un connecteur de raccordement correspondant 4. En poussant le châssis suffisamment à fond, on produit l'enfichage des éléments de connexion 3 et 4.

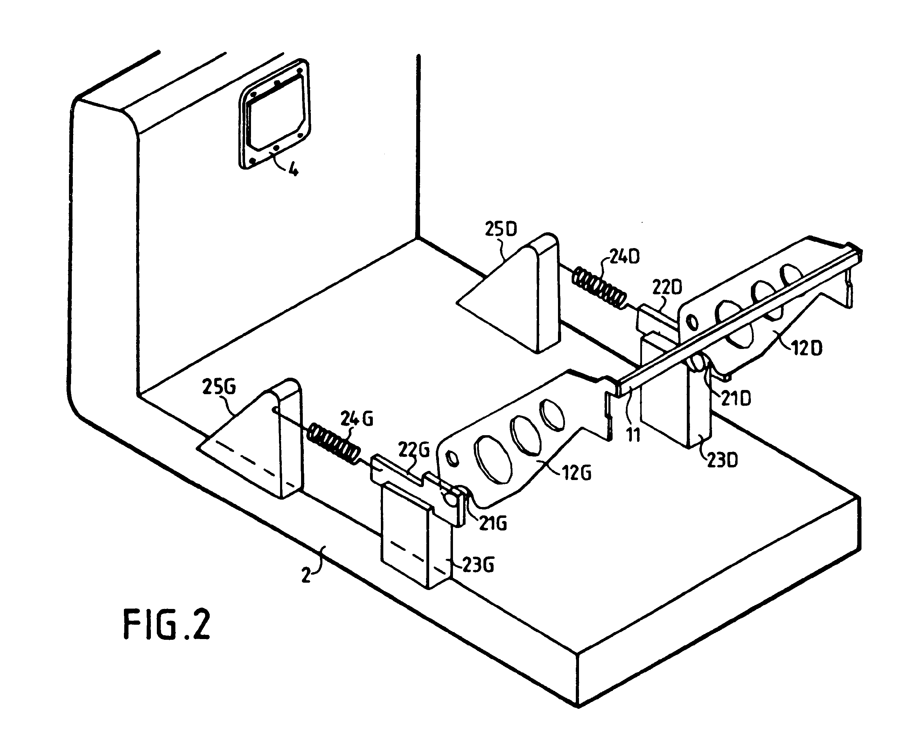

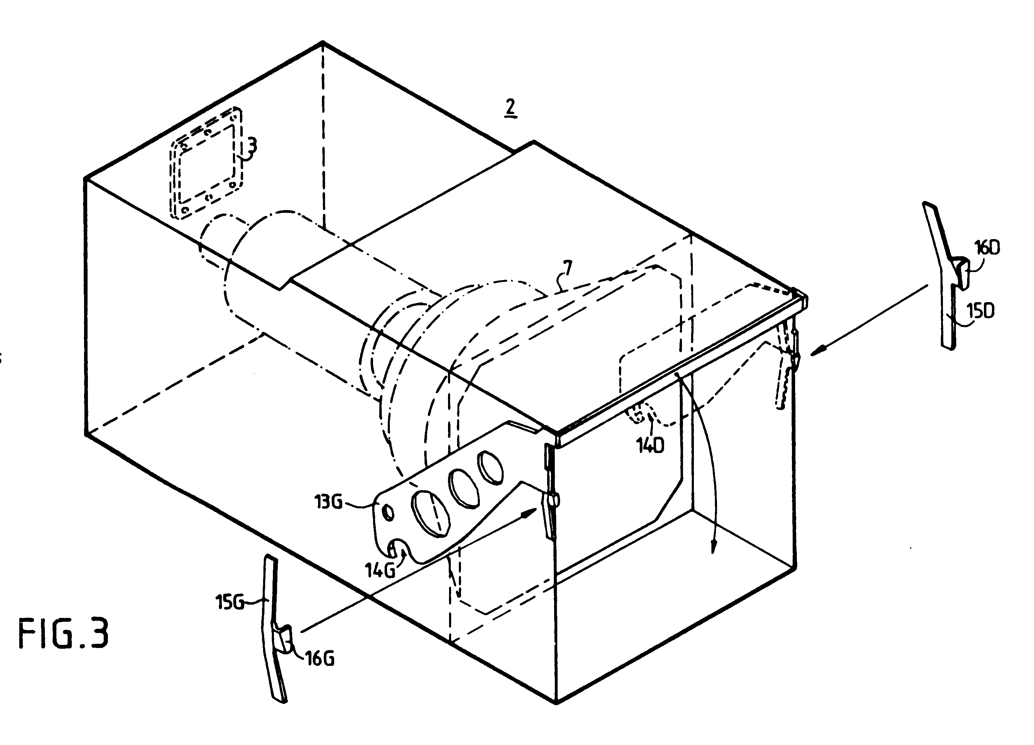

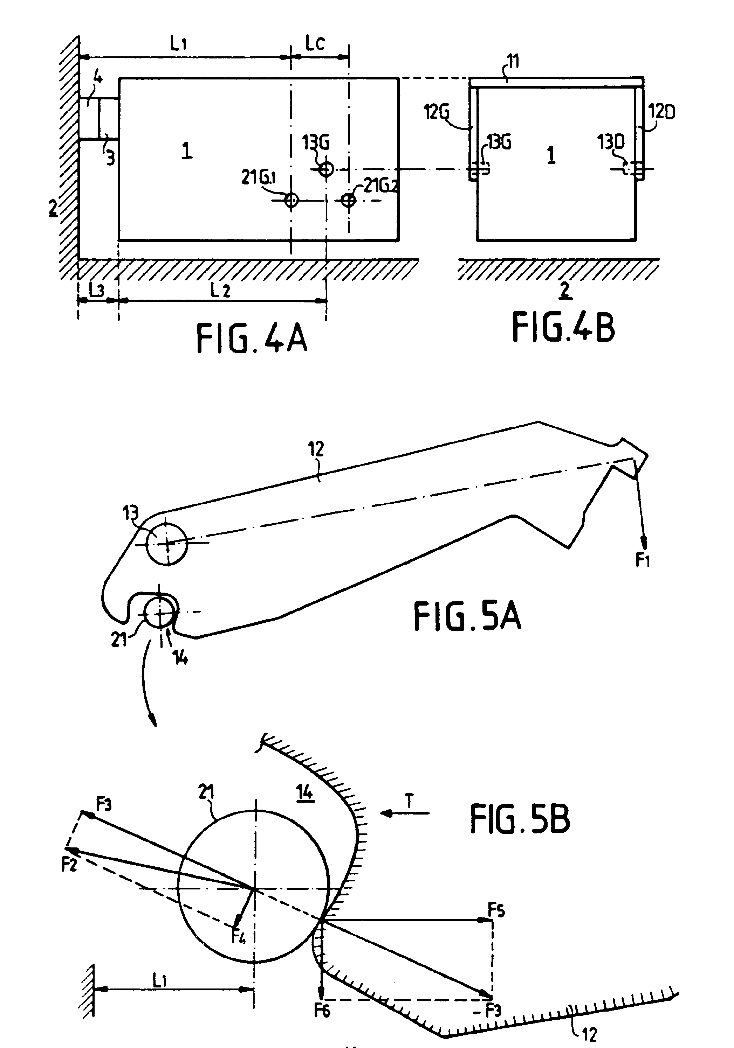

Le système de montage et de démontage comporte une poignée 11 reliée à deux bras qui vient se rabattre en position haute sur la face avant du châssis. Cette poignée a été rajoutée sur la figure 2 bien que ne faisant pas partie de l'équipement du bâti, de manière à montrer sa coopération par les deux bras latéraux gauche 12G et droite 12D avec les autres organes portés par le bâti 2. La poignée, de par ses dimensions, ne produit pratiquement pas d'effet de masque à l'avant comme on le voit nettement sur la figure 3 ou la figure 4B. Les bras 12G et 12D sont montés tournant respectivement autour de deux axes mécaniques 13G et 13D solidaires du châssis 1 chacun des bras comporte une partie échancrée 14G et 14D, la poignée et les bras sont maintenus verrouillés en position haute par un dispositif qui peut être constitué comme représenté par deux ressorts 15G et 15D. Chaque ressort est formé par une lame qui s'applatie sous l'effet de pression des bras lorsque la poignée est amenée en position haute, et comporte un bossage 16G et 16D sur lequel vient s'appuyer respectivement une surface inférieure du bras associé, le maintenant verrouillé en position haute. Pour le déverrouillage, il suffit d'appuyer simultanément sur les bossages 16G et 16D de façon à libérer à nouveau les bras et permettre un mouvement descendant de la poignée 11.

Les parties échancrées des bras sont prévues recevoir respectivement chacune un pion 21G et 21D. Chacun des pions est monté sur une pièce 22G et 22D qui peut être déplacée selon la direction T lors du montage, ou la direction inverse pour le démontage. Le déplacement selon la direction T de montage est limité par un organe de butée qui peut consister simplement en un usinage de forme particulière de la pièce support 22G et 22D pour qu'elle vienne en appui sur une pièce associée solidaire du bâti 2. Cette pièce peut être, comme représenté, respectivement la pièce 23G et 23D servant au guidage des éléments 22G et 22D. Chacune des pièces 22G et 22D est couplée mécaniquement à une extrémité d'un ressort 24G et 24D dont l'autre extrémité est fixée au bâti 2 directement ou par l'intermédiaire d'une pièce 25G et 25D.

Sur la figure 1, on a représenté en pointillés le châssis 10 en début de son introduction par coulissement sur le bâti support 2, les bras étant dans une position basse initiale 12G.0 permettant le passage du pion associé 21G dans l'échancrure correspondante 14G.0. La représentation en traits pleins correspond au montage terminé, la poignée 11 étant en position relevée et verrouillée vers le haut par les ressorts 15G et 15D.

La figure 2, représente plus particulièrement le bâti ou cadre support 2 avec les équipements de montage 21 à 25 auxquels sont rajoutés la poignée 11 et ses bras 12D et 12G pour une meilleure compréhension.

La figure 3 montre un châssis 2 comportant, selon une application plus particulière envisagée, un tube cathodique de visualisation 7. Sur cette figure les ressorts latéraux de verrouillage des bras en position haute 15D et 15G sont extraits et représentés en détail pour faire apparaître les surfaces de butée 16G et 16D sur lesquelles viennent reposer le bras.

La figure 4A indique les cotes essentielles respectées par le montage à savoir, la distance fixe L2 entre l'axe de rotation 13 des bras et le fond du châssis, la cote L3 entre le fond du châssis et le bâti c'est-à-dire l'épaisseur du dispositif connecteur 3-4 enfiché compris entre ces deux plans. La cote L1 représente la distance entre le bâti 2 et le pion 21G1 lorsque celui-ci est en butée et LC la course du pion pour amener celui-ci en position de travail 21G2 en fin de montage lors du blocage en position haute des bras. Ces éléments sont pris en compte pour déterminer notamment, lorsque les pions sont dans la position travail 21G2 et 21D2, une force de traction terminale des ressorts 24G et 24D compatible avec les données du fabricant des connecteurs, c'est-à-dire inférieure à la force de pression maximale supportable par les éléments connecteurs 3 et 4. En outre, ainsi qu'il a été dit précédemment, le montage est déterminé tel que la force de traction initiale du ressort dans la position 21G1 et 21D1 de butée des pions est supérieure à la force nécessaire pour translater le châssis et l'enficher en fin de course.

La figure 4B représente schématiquement la face avant du châssis et montre que celle-ci est quasi totalement dégagée moyennant une poignée 11 de faible largeur qui, en position haute, se trouvera généralement dans un endroit masqué naturellement et en dehors de l'écran de visualisation ou de la zone utile d'affichage.

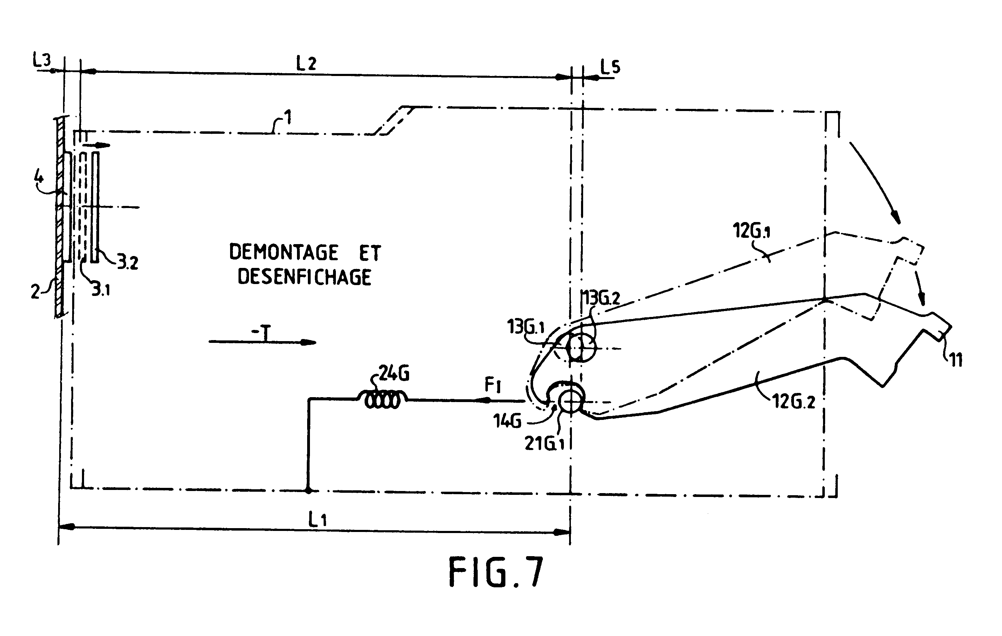

La figure 5A et le détail 5B représentent, en particulier, la forme de la partie échancrée 14 du bras (gauche ou droite) 12. On a représenté le bras 12 dans la position de démontage de la figure 7 où la surface avant de la partie échancrée appui sur le pion qui est en butée. Dans cette position, l'opérateur exerce sur la poignée 11 une force F1 vers le bas qui se traduit au niveau du pion 21 par une force F3 et une réaction inverse -F3 du côté du bras. Cette force de réaction -F3 est orientée vers le bas et peut être décomposée en F5 parallèle à la direction horizontale de déplacement T mais de sens inverse et F6 perpendiculaire à T. On voit que la composante verticale F6 est dirigée vers le bas et tend ainsi à plaquer le châssis 1 sur le bâti 2 ; la composante F5 tend, elle, à favoriser l'extraction du châssis 1 et le désenfichage.

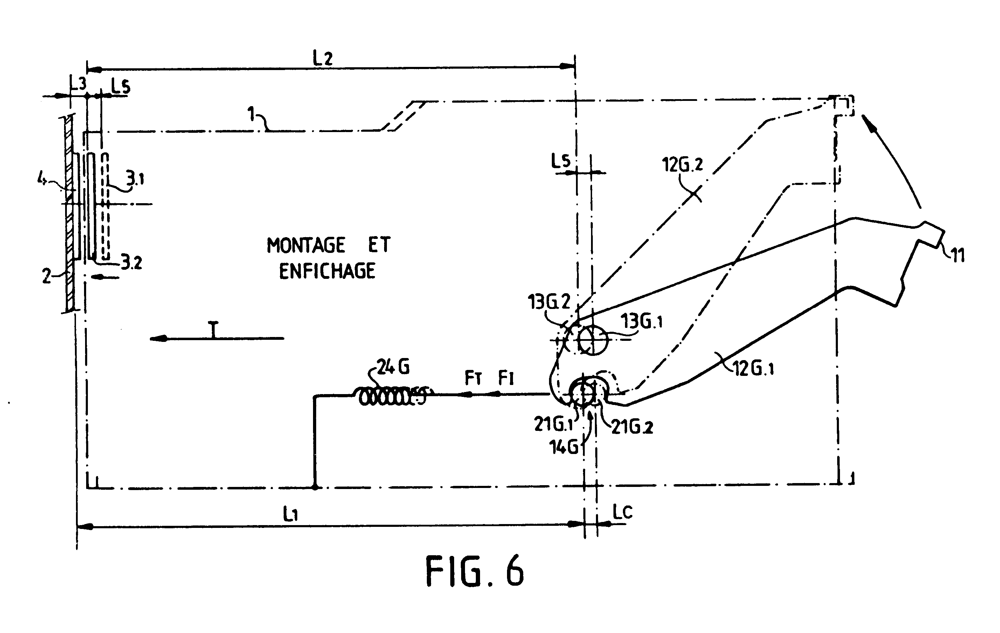

Il en est de même lors de l'opération de montage (voir figure 6), en soulevant la poignée 12 le pion 21 vient s'appuyer sur la surface arrière de la partie échancrée 14 ; la force de réaction correspondante va présenter une composante horizontale parallèle à T et de même sens, donc favorable à la mise en place du châssis 1 et à l'enfichage, et une composante verticale de cette force de réaction également dirigée vers le bas, comme F6 précédemment, et qui applique le châssis 1 sur le bâti 2.

La figure 6 représente le montage et l'enfichage. Le châssis est d'abord poussé par l'opérateur vers le fond du bâti 2 avec les bras en position basse (12G.0 figure 1) de manière à les engager sur les pions. Ce mouvement de translation horizontale est arrêté après mise en contact des connecteurs 3 et 4. Pour l'enfichage des connecteurs et le blocage du châssis l'opérateur relève la poignée 11 de manière, à engager les échancrures 14G et 14D sur les pions 21G.1 et 21D.1 en position butée. L'opérateur poursuit le mouvement de la poignée 11 vers le haut avec rotation des bras autour des axes 13G et 13D pour faire passer les bras de la position 12G.1 et 12D.1 à la position haute 12G.2 et 12D.2. Le levier constitué par la partie entre l'axe de rotation en 13 et la poignée 11 exerce une poussée au niveau des pions 21G.1 et 21D.1 qui permet de déplacer ces pions de la position butée 21G.1 et 21D.1 à la position travail 21G.2 et 21D.2 et leur fait parcourir une course LC à la fin de laquelle chaque ressort 24G et 24D produit une force de traction plus importante, passant de la valeur initiale FI à la valeur finale FT. Durant cette même phase, l'axe 13 s'est déplacé d'une quantité L5 selon la direction T et cette distance correspond à l'enfichage complet des connecteurs 3-4. La force résultante 2FI initiale résultant de la tension des deux ressorts 24G et 24D est supérieure à la force nécessaire à la translation horizontale du châssis. La résultante 2FT en position travail des pions est déterminée inférieure à la valeur de pression maximale préconisée pour les connecteurs. Cette résultante 2FT et le remontage des bras en position haute assurent le maintien en place du châssis malgré des conditions sévères d'utilisation, notamment du point de vue des vibrations mécaniques.

La figure 7 est relative au démontage et désenfichage. Par appui sur les parties latérales 16D et 16G des ressorts, on libère les bras et sous l'influence de la force 2FT l'ensemble 11-12 bascule pour venir dans la position 12G1 en appui sur le pion 21 lequel est revenu dans sa position de butée 21G.1. A cet instant les connecteurs sont enfichés dans la position initiale 4-3.1 . En appuyant vers le bas sur la poignée 11 on amène le bras dans la position 12G2. Les pions étant en butée 21G.1 et 21D.1 leur position ne change pas. Par contre, l'axe 13 se trouve déplacé d'une quantité suffisante L5 vers l'avant selon la direction -T inverse de celle du montage pour que le connecteur 3 vienne dans la position 3.2 où il se trouve désenfiché du connecteur 4. Il n'y a plus ensuite qu'à faire coulisser le châssis 1 vers l'extérieur pour le sortir complètement du bâti support 2, les bras tombent en position basse progressivement de par leur poids et n'accrochent pas au passage les pions dans leur partie échancrée 14.

## Revendications

1. Système de montage et de démontage rapide d'un châssis sur un bâti support, par translation horizontale du châssis, le système comportant :
   – une poignée (11) accessible à l'avant du châssis (1), couplée par ses extrémités à deux bras (12G et 12D) disposés latéralement au châssis l'un à droite, l'autre à gauche, et tournant respectivement autour de deux axes (13G et 13D) mécaniques solidaires du châssis, chacun des bras comportant une partie échancrée (14G et 14D) ;
   – deux pions (21G et 21D) venant respectivement se loger dans les parties échancrées des bras, le système étant caractérisé en ce que chaque pion est monté sur une pièce (22G et 22D) déplaçable selon la direction de translation du châssis et couplée mécaniquement à un ressort (24G, 24D) fixé au bâti, le ressort étant tendu pour exercer une force de traction selon ladite direction dans le sens de montage du châssis ; le système comportant en outre
   – un dispositif de verrouillage (15G et 15D) de la poignée en position haute et un dispositif de butée mécanique (22,23) limitant la course de chaque pièce support de pion selon ladite direction dans le sens du montage, la résultante des forces de traction des deux ressorts dans la position butée des deux pièces étant de valeur supérieure à celle nécessaire pour déplacer le châssis selon ladite translation.

2. Système selon la revendication 1, caractérisé en ce que la poignée (11) en position haute ne produit pas d'effet de masque pour l'observation de données sur la face avant du châssis.

3. Système selon la revendication 1 ou 2, caractérisé en ce que le montage est obtenu en procédant selon les étapes suivantes :
   – engagement horizontal du châssis (1) sur le bâti support (2) selon ladite direction de translation, la poignée (11) étant déverrouillée de son blocage (15) et ramenée vers le bas pour permettre l'engagement latéral de chaque pion (21) dans la partie échancrée (14) du bras associé (12) ;
   – amenée en butée du châssis sur le bâti chaque pion étant en position butée (21.1) ;
   – relèvement de la poignée, chaque partie échancrée présentant un flan arrière sur lequel appuie le pion au montage et un flan avant sur lequel appuie le pion au démontage, l'appui ayant lieu dans une position basse intermédiaire, de la poignée ;
   – action avec poussée vers le haut sur la poignée pour l'amener, par rotation des bras, dans la position haute et produire son verrouillage, ce mouvement entraînant le pion hors de butée avec accroissement de la tension du ressort.

4. Système selon la revendication 3, caractérisé en ce que le démontage est obtenu en procédant selon les étapes suivantes :

    – déblocage de la poignée (11) qui est rappelée par la force des ressorts dans une première position basse intermédiaire (12.1), les pions (21.1) venant en butée, ladite première position basse intermédiaire correspondant à l'appui du pion sur le flan avant présenté par la partie échancrée du bras associé ;

    – abaissement de la poignée en exerçant une poussée vers le bas pour l'amener dans une deuxième position plus basse et déplacement du châssis selon ladite direction de translation du pour l'extraire du bâti.

5. Système selon la revendication 3 ou 4, caractérisé en ce que le dispositif de verrouillage de la poignée est constitué de deux ressorts à lame (15) avec un bossage d'appui (16) pour assurer un verrouillage automatique de la poignée au montage, le déverrouillage étant produit par pression manuelle sur lesdits bossages.

6. Système selon l'une quelconque des revendications précédentes et dans lequel le châssis et le bâti sont équipés de connecteurs électriques avec enfichage au montage selon ladite translation et désenfichage au démontage selon un mouvement inverse, caractérisé en ce que la résultante des forces de traction des ressorts après montage et blocage du châssis est inférieure à la valeur maximale admissible par les connecteurs.

7. Système selon la revendication 2 considérée seule ou combinée avec l'une quelconque des revendications 3 à 6, caractérisé en ce que le châssis comporte un tube à rayons cathodiques.

**Patentansprüche**

1. System zum schnellen Ein- und Ausbauen eines Chassis an einem Trägergestell durch Horizontalverschiebung des Chassis, welches System folgendes aufweist:

    – einen von der Vorderseite des Chassis (1) zugänglichen Handgriff (11), der an seinen Enden mit zwei Armen (12G und 12D) verbunden ist, die seitlich am Chassis angebracht sind, der eine rechts, der andere links, und die sich um zwei Achsen (13G und 13D) drehen, die mechanisch fest mit dem Chassis verbunden sind, wobei jeder Arm einen Ausschnitt (14G und 14D) hat;

    – zwei Zapfen (21G und 21D), die jeweils von den Ausschnitten der Arme aufgenommen werden, welches System dadurch gekennzeichnet ist, daß jeder Zapfen auf einem in Verschieberichtung des Chassis verstellbaren Teil (22G und 22D) angebracht ist, das mechanisch mit einer fest am Gestell angebrachten Feder (24G, 24D) verbunden ist, welche Feder so gespannt ist, daß sie eine Zugkraft in der genannten Richtung in Einbaurichtung des Chassis ausübt; welches System ferner folgendes aufweist:

    – eine Verriegelungsvorrichtung (15G und 15D) für den Handgriff in einer oberen Stellung und

    – eine mechanische Anschlagvorrichtung (22, 23), die den Hub jedes Zapfen-Trägerteils in der genannten Richtung in Einbaurichtung begrenzt, wobei die Resultierende der Zugkräfte der zwei Federn in der Anschlagposition der zwei Teile einen Wert aufweist, der größer ist als derjenige, der erforderlich ist, um das Chassis bei der genannten Verschiebung zu verschieben.

2. System nach Anspruch 1, dadurch gekennzeichnet, daß der in der oberen Stellung befindliche Handgriff (11) keinen Abdeckeffekt in bezug auf die Beobachtbarkeit von Daten auf der Vorderseite des Chassis erzeugt.

3. System nach Anspruch 1 oder 2, dadurch gekennzeichnet, daß zum Einbau gemäß den folgenden Schritten vorgegangen wird:

    – horizontales Einsetzen des Chassis (1) in das Trägergestell (2) in der genannten Verschieberichtung, wobei der Handgriff (11) aus seiner Blockierung (15) entriegelt ist und nach unten geführt ist, um den seitlichen Eingriff jedes Zapfens (21) in den Ausschnitt (14) des zugeordneten Arms (12) zuzulassen;

    – Einführen des Chassis auf dem Gestell bis zum Anschlag, wobei sich jeder Zapfen in seiner Anschlagstellung (21.1) befindet;

    – Anheben des Handgriffs, bei dem jeder Ausschnitt einen hinteren Teil aufweist, gegen den der Zapfen beim Einbau drückt, und einen vorderen Teil aufweist, gegen den der Zapfen beim Ausbau drückt, wobei das Andrücken in einer unteren Zwischenstellung des Handgriffs erfolgt;

    – Betätigen des Handgriffs mit Druck nach oben, um ihn unter Drehung der Arme in die obere Stellung zu überführen und sein Verriegeln herbeizuführen, welche Bewegung der Zapfen vom Anschlag weg mitnimmt, unter Zunahme der Zugspannung der Feder.

4. System nach Anspruch 3, dadurch gekennzeichnet, daß zum Ausbau gemäß den folgenden Schritten vorgegangen wird:

– Entriegeln des Handgriffs (11), der durch die Kraft der Federn in eine erste untere Zwischenstellung (12.1) rückgeführt wird, wobei die Zapfen (21.1) zum Anschlag kommen, welche erste untere Zwischenstellung der Anlage des Zapfens am vorderen Teil des Ausschnitts des zugeordneten Arms entspricht;

– Absenken des Handgriffs durch Ausüben einer Druckkraft nach unten, um ihn in eine zweite, tiefere Stellung zu überführen, und Verschieben des Chassis in der genannten Verschieberichtung, die erforderlich ist, um es aus dem Gestell herauszuziehen.

5. System nach einem der Ansprüche 3 oder 4, dadurch gekennzeichnet, daß die Verriegelungsvorrichtung für den Handgriff durch zwei Blattfedern (15) mit einem Auflagevorsprung (16) gebildet wird, um ein automatisches Verriegeln des Handgriffs beim Einbau sicherzustellen, wobei das Entriegeln dadurch erfolgt, daß von Hand auf die genannten Vorsprünge gedrückt wird.

6. System nach einem der vorstehenden Ansprüche, bei dem das Chassis und das Gestell mit elektrischen Verbindern ausgestattet sind, die beim Einbau durch die genannte Verschiebung steckend kontaktiert und beim Ausbau durch eine entgegengesetzte Bewegung dekontaktiert werden, dadurch gekennzeichnet, daß die Resultierende der Zugkräfte der Federn nach dem Einbau und der Verriegelung des Chassis kleiner ist als der für die Verbinder zulässige Maximalwert.

7. System nach Anspruch 2 in Alleinstellung oder kombiniert mit einem der Ansprüche 3 bis 6, dadurch gekennzeichnet, daß das Chassis eine Kathodenstrahlröhre aufweist.

## Claims

1. System for the rapid assembling and dismantling of a frame on a supporting framework, by the horizontal translation of the frame, the system comprising:

– a handle (11) which is accessible from the front of the frame (1), coupled by its ends to two arms (12G and 12D) arranged laterally to the frame, one on the right, the other on the left, and respectively rotating about two spindles (13G and 13D) which are mechanical and rigidly connected to the frame, each of the arms comprising a notched portion (14G and 14D):

– two pins (21G and 21D) respectively coming to lodge in the notched portions of the arms, the system being characterised in that each pin is mounted on a part (22G and 22D) which can be moved in the translation direction of the frame and is mechanically coupled to a spring (24G, 24D) which is fixed to the framework, the spring being stretched in order to exert a traction force in the said direction in the direction for assembling the frame; the system comprising moreover

– a device (15G and 15D) for locking the handle in the top position, and

– a mechanical stop device (22, 23) limiting the travel of each pin support part in the said direction in the direction for assembly, the resultant of the traction forces of the two springs in the stop position of the two parts being of a greater value than that which is required in order to move the frame in the said translation.

2. System according to Claim 1, characterised in that the handle (11) in the top position does not have any masking effect on the observation of data on the front face of the frame.

3. System according to Claim 1 or 2, characterised in that the assembly is obtained by proceeding according to the following steps:

– horizontal engagement of the frame (1) on the support framework (2) in the said translation direction, the handle (11) being unlocked from its locking member (15) and brought downwards in order to permit the lateral engagement of each pin (21) in the notched portion (14) of the associated arm (12);

– bringing the frame to a stop on the framework, each pin being in the stopped position (21.1);

– lifting up the handle, each notched portion exhibiting a rear flank upon which the pin bears during assembly and a front flank upon which the pin bears during dismantling, the bearing taking place in a intermediate low position of the handle;

– action with thrust upwards on the handle in order to bring it, by rotation of the arms, into the top position and to produce its locking, this movement pulling the pin out of the stop with an increase in the tension of the spring.

4. System according to Claim 3, characterised in that the dismantling is obtained by proceeding according to the following steps:

– unlocking the handle (11) which is returned by the force of the springs into a first intermediate low position (12.1), the pins (21.1) coming against the stop, the said first intermediate low position corresponding to the bearing of the pin on the front flank exhibited by the notched portion of the associated arm;
– lowering the handle by exerting thrust downwards in order to bring it into a second lower position and displacing the frame in the said translation direction of the in order to extract it from the framework.

5. System according to Claim 3 or 4, characterised in that the device for locking the handle is constituted by two leaf springs (15) with a bearing boss (16) in order to provide automatic locking of the handle during assembly, unlocking being produced by manual pressure on the said bosses.

6. System according to any one of the preceding claims and in which the frame and the framework are equipped with electrical connectors that can plug in during assembly according to the said translation and unplug during dismantling according to a reverse movement, characterised in that the resultant of the traction forces of the springs after assembling and locking the frame is less than the maximum permissible value for the connectors.

7. System according to Claim 2 considered alone or combined with any one of Claims 3 to 6, characterised in that the frame comprises a cathode ray tube.

FIG.1

FIG.2

FIG.3

EP 0 323 926 B1

FIG.4A

FIG.4B

FIG.5A

FIG.5B

MONTAGE ET
ENFICHAGE

FIG. 6

EP 0 323 926 B1

DEMONTAGE ET
DESENFICHAGE

FIG.7

EP 0 323 926 B1